Europäisches Patentamt

(19) European Patent Office

Office européen des brevets

(11) Numéro de publication : **0 219 374 B1**

(12) # FASCICULE DE BREVET EUROPEEN

(45) Date de publication du fascicule du brevet :
02.01.91 Bulletin 91/01

(51) Int. Cl.⁵ : **H01L 21/603, B23K 20/14**

(21) Numéro de dépôt : **86401932.8**

(22) Date de dépôt : **02.09.86**

(54) **Dispositif de soudage par thermocompression.**

(30) Priorité : **03.09.85 FR 8513089**

(43) Date de publication de la demande :
**22.04.87 Bulletin 87/17**

(45) Mention de la délivrance du brevet :
**02.01.91 Bulletin 91/01**

(84) Etats contractants désignés :
**DE GB IT NL**

(56) Documents cités :
**DE-A- 2 236 699**
**GB-A- 2 137 914**
**US-A- 3 838 240**

(72) Inventeur : **Mur, Rémy**
**THOMSON-CSF SCPi 19, avenue de Messine**
**F-75008 Paris (FR)**
Inventeur : **Caugant, Jacques**
**THOMSON-CSF SCPi 19, avenue de Messine**
**F-75008 Paris (FR)**
Inventeur : **Guyot, Jean-Jacques**
**THOMSON-CSF SCPi 19, avenue de Messine**
**F-75008 Paris (FR)**

(74) Mandataire : **Benoit, Monique et al**
**THOMSON-CSF SCPI**
**F-92045 PARIS LA DEFENSE CEDEX 67 (FR)**

(73) Titulaire : **THOMSON-CSF**
**51, Esplanade du Général de Gaulle**
**F-92800 Puteaux (FR)**

**EP 0 219 374 B1**

Jouve, 18, rue Saint-Denis, 75001 PARIS

## Description

La présente invention concerne des dispositifs de soudage par thermocompression particulièrement destinés à la réalisation de soudures sur les fils de connexion des puces de circuits intégrés.

Ce type de soudage est réalisé généralement de manière semi-automatique par un opérateur qui utilise un microscope optique et un outil de thermocompression.

L'opérateur place les éléments les uns par rapport aux autres à l'aide du microscope optique lorsque ces éléments sont positionnés, l'opérateur rapporte le fil à souder et actionne l'appareil de manière à ce que la pointe de l'outil à thermocompression comprime le fil à souder à l'endroit où doit être effectuée la soudure, cette pointe ayant été préalablement portée à la température requise pour chauffer le fil à cet endroit.

On utilise le microscope pour réaliser cette opération qui est extrêmement délicate et qui demande une très grande précision sur des éléments qui sont de très petites dimensions.

L'outil comporte principalement un fourreau métallique à l'intérieur duquel est placée une tige qui émerge de ce fourreau et un élément chauffant qui porte la pointe à la température requise. La partie qui émerge, se présente sous forme d'une pointe d'environ 50 micromètres de diamètre. La pointe est portée à une température d'environ 200 à 500 degrés Celsius à l'aide de la résistance de chauffe qui est enroulée autour de la tige à l'intérieur du fourreau.

Au bout de quatre ou cinq heures d'utilisation la pointe devient absolument inefficace d'une part parce qu'elle a été détériorée par la présence d'une couche de calamine qui la recouvre et d'autre part parce que la brasure qui permet de fixer l'élément chauffant sur la tige se détériore également par oxydation. La pointe n'assure plus l'échange thermique nécessaires à la thermocompression et la bra- sure décomposée, se dépose sur le substrat et les composants, ce qui nuit à la fiabilité de la soudure.

En effet, pour réaliser des soudures par thermocompression de manière fiable il faut d'une part que la pointe de l'outil ait une dimension très précise qui ne varie pas au cours de l'utilisation et d'autre part que sa température soit constante pendant l'utilisation. Lorsque la calamine recouvre cette pointe, ses dimensions sont modifiées et l'empreinte qu'elle laisse ne convient plus pour réaliser une bonne compression, par ailleurs la température de la pointe ayant chutée la thermocompression ne sera pas efficace. Les résultats montrent que, en général au bout de deux heures de chauffage de la pointe celle-ci s'est recouverte d'une couche de calamine d'environ 30 μm ce qui est considérable par rapport aux dimensions initiales de la pointe.

Du Brevet US-A- 3838240 est connu un dispositif par compression comportant tous les éléments du préambule de la revendication 1. Cependant dans ce dispositif la tige et la pointe sont excentrés l'une par rapport à l'autre et par rapport au reste du dispositif. Contrairement à ce dispositif connu, celui de l'invention tel que défini par l'invention permet d'obtenir un outil symétrique de révolution limitant les mouvements parasites de la pointe en cours de travail.

D'autres particularités et avantages de la présente invention apparaîtront clairement à la lecture de la description suivante présentée à titre d'exemple non limitatif et fait à regard des figures du dessin annexé qui représente :

- figure 1, un outil de thermocompression selon l'invention

- figure 2, des courbes représentant une comparaison des conditions d'utilisation de l'outil selon l'art antérieur et l'invention.

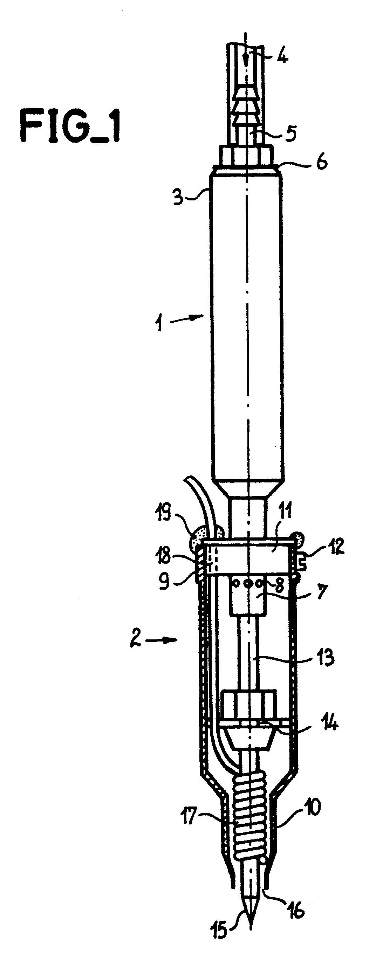

La figure 1 représente un dispositif de thermocompression selon l'invention. Ce dispositif comporte un corps 1 qui servait uniquement de support au fourreau 2 selon l'art antérieur et qui permet selon l'invention le passage d'un gaz vers le fourreau. Ce corps est un cylindre creux dont une extrémité 3 est reliée à une amenée de gaz 4 au moyen d'un raccord à tétine 5. Un joint en caoutchouc 6 permet de réaliser une étanchéité dans la jonction entre l'extrémité 3 du corps et le raccord 5. L'autre extrémité 7 du corps pénètre à l'intérieur du fourreau 2. Cette extrémité 7 est pourvue de trous 8 qui permettent le passage du gaz à l'intérieur du fourreau.

Le fourreau 2 a également une forme cylindrique. Il comporte une partie supérieure 9 reliée directement au corps 1 et une partie inférieure 10 de diamètre plus petit que celui de la partie supérieure de laquelle émerge la pointe de thermocompression. La partie supérieure 9 du fourreau est obturée par une pièce 11 solidaire du corps 1 qui est placée au dessus de l'extrémité 7 où sont situés les trous 8. Des vis de fixation 12 permettent de maintenir l'extrémité 9 du fourreau autour de cette pièce 11 et de solidariser l'ensemble.

Une tige 13 est placée à l'intérieur du fourreau, cette tige est maintenue verticalement à l'intérieur du fourreau à l'aide d'un écrou de maintien et de guidage 14. Cette tige 13 émerge en son extrémité de la partie inférieure du fourreau, la partie qui émerge se terminant en forme de pointe 15. Dans sa partie située entre l'écrou de maintien et la pointe, la tige 13 est entourée d'un élément chauffant 17. Cet élément se prolonge jusqu'à l'obturation 11 du fourreau, traverse celui-ci par un trou de guidage 18 et émerge de manière à être relié à des moyens de chauffage classiques qui ne sont pas représentés sur cette figure. L'étanchéité autour du trou 18 est réalisée à l'aide d'un ciment céramique 19. Lorsque le dispostif de chauffage est en fonctionnement l'élément 17 chauffe l'extrémité de la tige dans les conditions désirées.

Pendant le fonctionnement de l'outil de compression un gaz neutre est injecté avec un débit prédéterminé qui permet de maintenir l'élément chauffant et la pointe dans une atmosphère neutre ce qui évite toute oxydation de ces éléments. Le gaz utilisé peut par exemple être un gaz rare ou de l'azote ou bien un gaz légèrement réducteur comme le mélange d'hydrogène et d'azote $N_2(80) + H_2(20)$. L'arrivée du gaz dans le fourreau se fait à l'aide des trous 8 qui ont été perforés dans la partie 7 du corps, le gaz se répartit à l'intérieur du fourreau et maintient la tige dans cette atmosphère neutre ou légèrement réductrice, le gaz s'échappe par l'extrémité 16 du fourreau et en s'échappant il maintient cette atmosphère neutre ou légèrement réductrice autour de la pointe 15.

L'injection d'un gaz neutre ou légèrement réducteur caloporteur à l'intérieur même du fourreau de l'outil de thermocompression permet à la fois de maintenir dans une atmosphère neutre l'élément chauffant et la pointe de thermocompression. L'injection du gaz à l'intérieur du fourreau permet également d'assurer un transfert des calories à l'intérieur de ce fourreau sous la pointe de l'outil si bien que les courants utilisés pour le chauffage de l'élément conducteur peuvent être moins élevés pour une température de pointe d'outil plus élevée ce qui a pour conséquence de diminuer la durée pendant laquelle peut être réalisée la compression. En effet, la durée du temps de compression est diminuée de 50% ce qui a pour avantage de diminuer le risque de la thermocompression sur les composants fragiles (diodes, transistors).

Les plages de fonctionnement en température se situent aux alentours de 100°C pour le préchauffage de la pointe et au dessus de 280°C pour effectuer la thermocompression, cette température pouvant être élevée jusqu'à pratiquement 500°C pour un courant de 1,8 A.

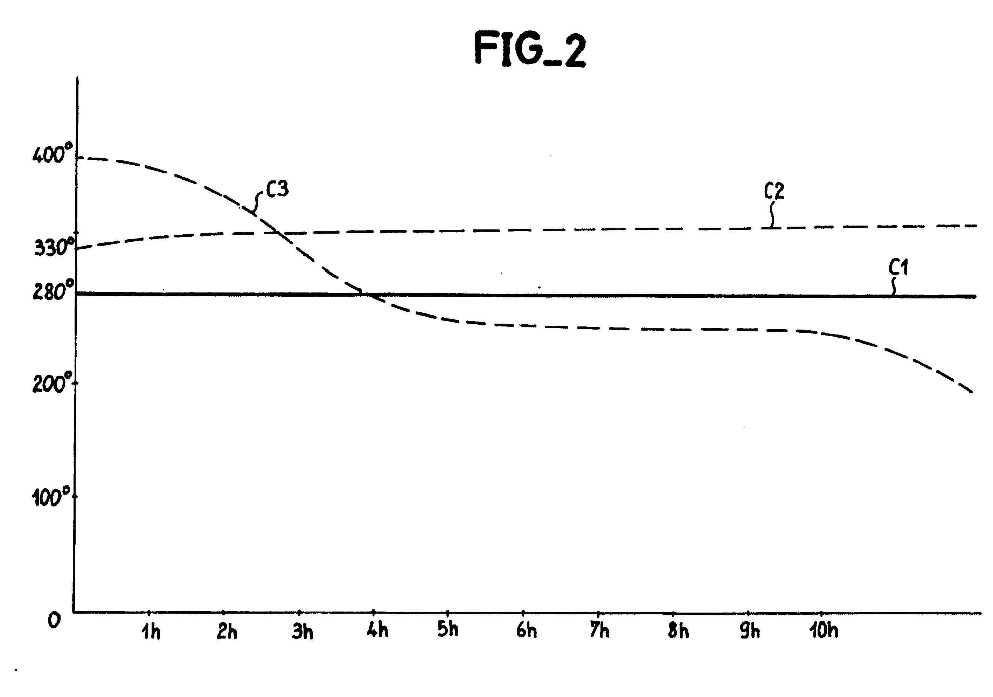

Sur la figure 2, on a représenté deux courbes mettant en évidence les conditions d'utilisation de l'outil de thermocompression. Ces courbes représentent la durée de vie de la pointe en fonction de la température de chauffage en degrès Celsius.

En abscisse on a représenté la durée, en heure, et en ordonnée on a représenté les degrès Celsius. On a représenté une courbe C1 qui est en fait une droite correspondant à la température minimale requise pour obtenir un effet de thermocompression, cette température étant de 280°C. La courbe C2 représente l'évolution de la température de chauffe au cours du temps pour l'outil de thermocompression selon l'invention. Pour un fil rapporté de 25 um de diamètre un courant de 1,5 A et un débit de gaz de 100cm3 par minute, la température se situe aux alentours de 330°C et est quasiment constante dans la plage de temps qui est représentée, cette température est constante pratiquement pour une centaines d'heures d'utilisation. La courbe C3 représente l'évolution de la température de chauffe pour l'outil de thermocompression selon l'art antérieur. Pour un fil de même diamètre c'est-à-dire de 25 um et un courant de 2 A la température qui est de 400°C au départ décroît très rapidement se trouve à 330°C au bout de trois heures et chute en dessous de 280°C au bout de quatre heures d'utilisation. Entre quatre heures et huit heures et demie d'utilisation la température est insuffisante il y a donc des risques sur la fiabilité des thermocompressions qui sont réalisés. Au delà de cette durée la pointe est ébréchée et l'empreinte laissée par la thermocompression devient doublement inefficace.

La présente invention a donc pour avantage de supprimer l'oxydation au niveau de l'élément conducteur qui permet le chauffage de la pointe de thermocompression et de supprimer également l'oxydation au niveau de cette pointe ce qui rallonge la durée de vie de la pointe considérablement puisque d'une durée d'utilisation d'environ quatre à cinq heures on passe à une durée d'utilisation d'environ une centaine d'heures tout en limitant les phénomènes de mouvements parasites de la pointe en cours de travail.

La présente invention a également pour avantage de diminuer le temps de compression ce qui résulte du fait que la pointe peut être chauffée à une température beaucoup plus élevée pendant un temps plus court sans risque pour le fourreau puisque le gaz fait office d'élément refroidissant.

La présente invention a également pour avantage de permettre un guidage automatique du fil à souder. En effet ce fil est rapporté au niveau de la pointe et guidé à l'aide d'un trou de diamètre légèrement supérieur à celui du fil pour permettre le passage du fil. Ce trou qui est perforé sur une patte support placée à proximité de la pointe se trouvait très rapidement obturé par la calamine ce qui obligeait un opérateur à gratter régulièrement pour permettre son passage. La suppression de la formation de cette calamine permet donc d'utiliser un dispositif de guidage automatique pour le fil.

**Revendications**

1. Dispositif de soudage par thermocompression comprenant une tige (13) reliée à une pointe (15) et placée à l'intérieur d'un fourreau (2) et un élément de chauffage (17) positionné autour de la partie inférieure de la tige (13),permettant d'une part, le chauffage direct de la pointe (15), et, d'autre part, le chauffage d'un gaz neutre injecté dans le fourreau (2) et dirigé sur la pointe (15) pour la chauffer et créer une atmosphère non oxydante, dispositif caractérisé en ce que la tige (13) émerge en son extrémité de la partie inférieure du fourreau (2) pour former la dite pointe (15).

2. Dispositif selon la revendication 1, caractérisé en ce que les moyens d'injection de gaz comprennent une conduite de gaz (1) relié au fourreau (2) et pénétrant à l'intérieur du fourreau (2), et comportant des sorties de gaz à l'intérieur du fourreau de manière à ce que le gaz s'échappe et qu'il s'établisse des courants de gaz neutre ou réducteur autour de l'élément chauffant et de la pointe.

3.Dispositif selon la revendication 1 ou 2,caractérisé en ce que le fourreau (2) comporte dans sa partie supérieure (9) un élément obturateur (11) empêchant le gaz de s'échapper par cette extrémité.

4.Dispositif selon la revendication 3, caractérisé en ce que l'élément obturateur (11) comporte un trou de guidage (12) qui permet de sortir une extrémité de l'élément chauffant (17) et un orifice qui permet de faire pénétrer la conduite de gaz à l'intérieur du fourreau.

5.Dispositif selon l'une quelconque des revendications 1 à 4, caractérisé en ce que le gaz utilisé est soit de l'azote, soit un gaz rare caloporteur.

6.Dispositif selon l'une quelconque des revendications 1 à 5, caractérisé en ce que le gaz utilisé est le mélange d'hydrogène et d'azote $N_2(80)+H_2(20)$.

## Claims

1.A device for thermocompression welding, comprising a shaft (13) connected to a tip (15) and placed inside a jacket (2), and a heating element (17) placed around the lower part of the shaft (13), allowing on the one hand to directly heat up the tip (15) and on the other hand to heat up a neutral gas injected into the jacket (2) and directed toward the tip (15) in order to heat it up and create a non-oxidizing atmosphere, characterized in that the shaft (13) projects at its end from the lower part of the jacket (2) so as to form said tip (15).

2.A device according to claim 1, characterized in that the means for injecting the gas comprise a gas duct (1) connected to the jacket (2) and penetrating into the jacket (2) and including gas outlets inside the jacket such that the gas escapes and a flow of neutral or reducing gas is established around the heating element and the tip.

3.A device according to claim 1 or 2, characterized in that the jacket (2) includes in its upper part (9) an obturating element (11) adapted to prevent the gas from escaping from said end.

4.A device according to claim 3, characterized in that the obturating element (11) includes a guidance hole (18) which allows one end of the heating element (17) to pass therethrough, and an orifice which allows to insert the gas duct into the jacket.

5.A device according to any one of the preceding claims 1 to 4, characterized in that the gas employed is either nitrogen or else a heat transferring noble gas.

6.A device according to any one of the claim 1 to 5, characterized in that the gas employed is a mixture of hydrogen and nitrogen $N_2(80)+H_2(20)$.

## Ansprüche

1.Vorrichtung zum Thermokompressionsschweißen, mit einem Stößel (13), der mit einer Spitze (15) verbunden und im Inneren einer Hülse (2) angeordnet ist, und mit einem Heizelement (17), das um den unteren Teil des Stößels (13) herum angeordnet ist und einerseits die direkte Aufheizung der Spitze (15) und andererseits die Aufheizung eines in die Hülse (2) eingespeisten und auf die Spitze (15) gerichteten neutralen Gases zu deren Erwärmen und zum Herstellen einer nicht oxidierenden Atmosphäre ermöglicht, dadurch gekennzeichnet, daß der Stößel (13) mit seinem Ende aus dem unteren Teil der Hülse (2) hervortritt und die Spitze (15) bildet.

2.Vorrichtung nach Anspruch 1, dadurch gekennzeichnet, daß die Mittel zur Einspeisung des Gases eine mit der Hülse (2) verbundene und in das Innere der Hülse eindringende Gasleitung (1) aufweisen, die im Inneren der Hülse (2) Gasauslässe besitzt, derart, daß das Gas austritt und sich um das Heizelement und um die Spitze einer Strömung neutralen oder reduzierenden Gases ausbildet.

3.Vorrichtung nach den Ansprüchen 1 oder 2, dadurch gekennzeichnet, daß die Hülse (2) in ihrem oberen Teil (9) ein Verschlußelement (11) besitzt, das das Gas an diesem Ende am Entweichen hindert.

4.Vorrichtung nach Anspruch 3, dadurch gekennzeichnet, daß das Verschlußelement (11) ein Führungsloch (18) aufweist, das den Durchtritt eines Endes des Heizelements (17) ermöglicht, und eine Öffnung, die das Einführen der Gasleitung in das Innere der Hülse ermöglicht.

5.Vorrichtung nach einem beliebigen der Ansprüche 1 bis 4, dadurch gekennzeichnet, daß entweder Stickstoff oder ein Edelgas als Wärmeträgergas verwendet wird.

6.Vorrichtung nach einem beliebigen der Ansprüche 1 bis 5, dadurch gekennzeichnet, daß das benutzte Gas aus einer Mischung von Wasserstoff und Stickstoff mit den Anteilen $N_2(80)+H_2$ (20) besteht.

# FIG_1

# FIG_2

EP 0 219 374 B1